# EUROPEAN PATENT APPLICATION

(11) **EP 2 755 241 A1**
(43) Date of publication of application: **16.07.2014**
(21) Application number: 12830337.7
(22) Date of filing: 04.09.2012
(51) Int. Cl.: H01L 31/04

(54) **THIN FILM PHOTOELECTRIC CONVERSION DEVICE AND METHOD FOR MANUFACTURING SAME**

(30) Priority: 07.09.2011 JP 2011195190
(71) Applicant: Kaneka Corporation, Osaka-shi, Osaka 530-8288 (JP)
(72) Inventor: KADOTA, Naoki, Otsu-shi, Shiga 520-0104 (JP); SASAKI, Toshiaki, Otsu-shi, Shiga 520-0104 (JP)
(74) Representative: HOFFMANN EITLE
(86) International application number: PCT/JP2012/072443
(87) International publication number: WO 2013/035686

(57) **Abstract**

The present invention relates to a thin-film photoelectric conversion device including an amorphous germanium photoelectric conversion layer (53). The thin-film photoelectric conversion device includes an amorphous germanium photoelectric conversion unit (5). The amorphous germanium photoelectric conversion unit (5) includes an amorphous germanium photoelectric conversion layer (53), which is substantially intrinsic and is essentially free of silicon atom, between a p-type semiconductor layer (51) and an n-type semiconductor layer (54). In a thin-film photoelectric conversion device according to one embodiment of the present invention, a crystalline silicon photoelectric conversion unit (4) including a crystalline silicon photoelectric conversion layer (43) is arranged on the light incident side of the amorphous germanium photoelectric conversion unit (5). In this embodiment, it is preferable that the amorphous germanium photoelectric conversion unit (5) has a quantum efficiency of 30% or more at a wavelength of 900 nm.

## Description

### TECHNICAL FIELD

The invention relates to a thin-film photoelectric conversion device including an amorphous germanium photoelectric conversion layer. In addition, the invention relates to a method for manufacturing a thin-film photoelectric conversion device.

### BACKGROUND ART

In view of the concern that energy problems and environmental problems will become serious in the future, development of alternative energies that replace fossil fuels has been eagerly carried out. Among the candidates for alternative energy sources, a photoelectric conversion device that converts light into electricity by using a photoelectric effect inside of a semiconductor is attracting attention, and a thin-film photoelectric conversion device using a silicon-based thin-film as a photoelectric conversion layer has been widely researched and developed.

The photoelectric conversion layer is a layer that absorbs light to generate an electron and hole pair, and thus its absorption property correlates well with an electrical generation property of the thin-film photoelectric conversion device. For example, the optical forbidden band width of an amorphous silicon semiconductor is about 1.8 eV, and when an amorphous silicon thin-film is used for the photoelectric conversion layer, light having a wavelength shorter than 800 nm can be absorbed to contribute to photoelectric conversion. The optical forbidden band width of a crystalline silicon semiconductor is about 1.1 eV, and long-wavelength light having a wavelength of 800 nm or more can be subjected to photoelectric conversion. With respect to an amorphous silicon germanium semiconductor, the optical forbidden band width can be adjusted in a range of about 1.8 to 1.1 eV by changing its composition.

As a method for improving conversion efficiency by utilizing a wider wavelength range of sunlight for photoelectric conversion, multi-junction thin-film photoelectric conversion devices are studied. The multi-junction thin-film photoelectric conversion device includes a plurality of photoelectric conversion units, and semiconductors having different optical forbidden band widths can be used as photoelectric conversion layers for respective photoelectric conversion units. Therefore, by devising a semiconductor material to be used for the multi-junction thin-film photoelectric conversion device, and a stacking structure, sunlight energy over a wider wavelength range may be utilized for photoelectric conversion.

However, the above-described silicon-based thin-film does not sufficiently absorb light having a wavelength longer than 900 nm, particularly light having a wavelength longer than 1000 nm, and even when photoelectric conversion units including these silicon-based thin-films as a photoelectric conversion layer are brought into multi-junction, there are limits on the extent to which efficiency of utilization of long-wavelength light is enhanced to improve conversion efficiency. On the other hand, light having a wavelength longer than 900 nm constitutes about 30% of irradiation energy of sunlight falling onto the ground. Therefore, in order to enhance efficiency of the thin-film photoelectric conversion device, it is desired to develop a semiconductor capable of efficiently utilizing light having a longer wavelength for photoelectric conversion.

Studies have been conducted on crystalline germanium, in addition to crystalline silicon, as a semiconductor capable of efficiently utilizing long-wavelength light for photoelectric conversion (Patent Document 1, for example). Crystalline germanium is a narrow-band-gap material having an optical forbidden band width of about 0.7 eV, and is therefore suitable for photoelectric conversion of long-wavelength light. However, crystalline germanium has a light absorption coefficient smaller than that of amorphous silicon etc. Therefore, for matching generated photocurrents from photoelectric conversion units when an amorphous silicon photoelectric conversion unit including an amorphous silicon thin-film and a crystalline germanium photoelectric conversion unit including a crystalline germanium thin-film are brought into multi-junction, the crystalline germanium photoelectric conversion layer should be made to have a thickness which is about 5 to 10 times the thickness of the amorphous silicon photoelectric conversion layer. Crystalline germanium is not easily formed into a uniform film with a large area as compared to an amorphous film. Thus, a thin-film photoelectric conversion device including a crystalline germanium photoelectric conversion layer is suitable for photoelectric conversion of long-wavelength light, but has difficulty in enhancement of productivity.

In addition to those described above, studies have been conducted on amorphous germanium as a semiconductor capable of utilizing long-wavelength light for photoelectric conversion. For example, Patent Document 2 discloses a multi-junction thin-film photoelectric conversion device with an amorphous silicon photoelectric conversion unit, an amorphous germanium photoelectric conversion unit and an amorphous germanium photoelectric conversion unit stacked from the light incident side. It is reported that the multi-junction thin-film photoelectric conversion device has the following characteristics: an open circuit voltage (Voc) of 2.55 V, a short circuit current density (Jsc) of 5.6 mA/cm², a fill factor (FF) of 0.64 and a conversion efficiency (Eff) of 9.14%. Patent Document 3 discloses a multi-junction thin-film photoelectric conversion device with a compound semiconductor photoelectric conversion unit, an amorphous silicon photoelectric conversion unit and an amorphous germanium photoelectric conversion unit stacked from the light incident side.

It is reported in Patent Document 3 and Non-Patent Document 1 that the optical forbidden band width of amorphous germanium is about 1.1 eV. This value is comparable to the optical forbidden band width of a crystalline silicon semiconductor. It is reported in Non-Patent Document 1 that a single-junction thin-film photoelectric conversion device including an amorphous germanium photoelectric conversion layer has a quantum efficiency of about 20% at a wavelength of 900 nm, and the photoelectric conversion device has a low fill factor of 0.59 because the amorphous germanium semiconductor layer has a large number of defects. Patent Document 2 describes that the optical forbidden band width of amorphous germanium is 0.9 to 1.0 eV, and a high-refractive-index amorphous germanium film having a reduced defect density has a small light absorption coefficient in an order of 10¹ cm⁻¹ at around 0.9 eV to 1.0 eV (wavelength longer than 1200 nm) as measured by photothermal deflection spectroscopy (PDS). Therefore, the actual optical forbidden band width is about 1.1 eV, a value comparable to that disclosed in Patent Document 3 etc., and it is hard to say that a high-quality amorphous germanium film capable of sufficiently utilizing long-wavelength light is obtained (see FIG. 3 in Patent Document 2).

Thus, in conventional techniques, it has been known that amorphous germanium has an optical forbidden band width comparable to that of crystalline silicon, and low photoelectric conversion characteristics for long-wavelength light as compared to crystalline silicon because there are a large number of defects. An amorphous material is known to undergo deterioration of characteristics when irradiated with light (Staebler-Wronski effect), and has the problem that when a multi-junction thin-film photoelectric conversion device is formed using only an amorphous material, deterioration of characteristics due to photodegradation is significant. Therefore, currently, a multi-junction-type photoelectric conversion device using amorphous silicon and crystalline silicon, which is capable of utilizing light in a wide wavelength region for photoelectric conversion and has reduced photodegradation, comes into practical use and has been actively developed.

### PRIOR ART DOCUMENTS

### PATENT DOCUMENTS

Patent Document 1: International Publication No. WO 2010/024211
Patent Document 2: Japanese Patent Laid-open Publication No. 1-246362
Patent Document 3: Japanese Patent Laid-open Publication No. 2010-267934

### NON-PATENT DOCUMENT

Non-Patent Document 1: J. Zhu et al., Journal of Non-Crystalline Solids, 338-340 (2004), pages 651 to 654

### SUMMARY OF THE INVENTION

### PROBLEMS TO BE SOLVED BY THE INVENTION

As described above, in conventional techniques, an amorphous germanium semiconductor layer has a large number of defects and is thus poor in practicability. Since the optical forbidden band width of amorphous germanium is almost comparable to the optical forbidden band width of crystalline silicon, it has been thought that even when a crystalline silicon photoelectric conversion unit and an amorphous germanium photoelectric conversion unit are stacked to be brought into multi-junction, improvement of utilization efficiency of long-wavelength light cannot be expected, and therefore there is no advantage in bringing the units into multi-junction. Thus, sufficient studies have not been conducted on photoelectric conversion devices using amorphous germanium, and it is hard to say that studies on improvement of film quality of amorphous germanium semiconductor layers and on multi-junction thin-film photoelectric conversion devices using an amorphous germanium photoelectric conversion unit are sufficient in the present circumstances.

In view of the above-mentioned situations, an object of the present invention is to provide a thin-film photoelectric conversion device including an amorphous germanium semiconductor layer having high film quality. Further, an object of the present invention is to provide a multi-junction thin-film photoelectric conversion device which is capable of effectively utilizing sunlight in a wide wavelength region and has reduced photodegradation.

### MEANS FOR SOLVING THE PROBLEMS

In view of the above circumstances, the inventors have conducted studies, and resultantly found that by improving film quality of amorphous germanium, a thin-film photoelectric conversion device including an amorphous germanium photoelectric conversion layer having high utilization efficiency of long-wavelength light is obtained. The new finding has been obtained that a multi-junction thin-film photoelectric conversion device with a crystalline silicon photoelectric conversion unit arranged on the light incident side of an amorphous germanium photoelectric conversion unit can cause sunlight energy to contribute to photoelectric conversion in a wider wavelength region. Further, it has been found that when an amorphous silicon-based photoelectric conversion unit is provided at the light incident side, a multi-junction thin-film photoelectric conversion device having improved conversion efficiency, reduced photodegradation and high post-stabilization conversion efficiency is obtained, leading to the present invention.

One embodiment of the present invention relates to a multi-junction thin-film photoelectric conversion device in which a first electrode layer, two or more photoelectric conversion units and a second electrode layer are arranged in this order on a substrate. Each photoelectric conversion unit includes a substantially intrinsic photoelectric conversion layer between a p-type semiconductor layer and an n-type semiconductor layer. In the multi-junction photoelectric conversion device, one of the photoelectric conversion units is an amorphous germanium photoelectric conversion unit including an amorphous germanium photoelectric conversion layer essentially free of silicon atom, and a crystalline silicon photoelectric conversion unit having a crystalline silicon photoelectric conversion layer is arranged on the light incident side of the amorphous germanium photoelectric conversion unit. Further, in the multi-junction thin-film photoelectric conversion device of the present invention, it is preferable that an amorphous silicon-based photoelectric conversion unit including an amorphous silicon-based photoelectric conversion layer is arranged on the light incident side of the crystalline silicon photoelectric conversion unit. In this specification, the "silicon-based" material includes not only silicon but also silicon alloy semiconductor materials such as silicon carbide and silicon germanium.

In the multi-junction thin-film photoelectric conversion device of the present invention, the amorphous germanium photoelectric conversion unit preferably has a quantum efficiency of 30% or more at a wavelength of 900 nm. Further, in the amorphous germanium photoelectric conversion unit, it is preferable that an interface layer made of a substantially intrinsic amorphous silicon semiconductor is provided between the p-type semiconductor layer and the amorphous germanium photoelectric conversion layer. The thickness of the interface layer is preferably in the range of 1 nm to 10 nm.

In addition, one embodiment of the present invention relates to a thin-film photoelectric conversion device in which a first electrode layer, an amorphous germanium photoelectric conversion unit including an amorphous germanium photoelectric conversion layer between a p-type semiconductor layer and an n-type semiconductor layer, and a second electrode layer are arranged in this order on a substrate. The amorphous germanium photoelectric conversion unit preferably has a quantum efficiency of 30% or more at a wavelength of 900 nm.

Further, the present invention relates to a manufacturing method of the above thin-film photoelectric conversion device. In the manufacturing method of the present invention, the amorphous germanium photoelectric conversion layer is formed by a plasma-enhanced CVD method. In the plasma-enhanced CVD, a hydrogen gas in an amount which is 1000 to 3000 times the amount of a germanium containing gas is introduced into a deposition chamber.

### EFFECTS OF THE INVENTION

A thin-film photoelectric conversion device of the present invention includes an amorphous germanium semiconductor layer having high film quality, and is excellent particularly in utilization efficiency of long-wavelength light, so that sunlight in a wide wavelength region can be caused to contribute to photoelectric conversion. In a multi-junction thin-film photoelectric conversion device, the thickness of an amorphous silicon-based photoelectric conversion layer arranged on the light incident side of the amorphous germanium photoelectric conversion unit can be decreased, and therefore a multi-junction thin-film photoelectric conversion device having reduced photodegradation and high post-stabilization conversion efficiency is obtained.

### BRIEF DESCRIPTION OF THE DRAWINGS

FIG. 1 is a schematic cross-sectional view that shows a single-junction thin-film photoelectric conversion device in accordance with one embodiment of the invention.
FIG. 2 is a schematic cross-sectional view that shows a single-junction thin-film photoelectric conversion device in accordance with one embodiment of the invention.
FIG. 3 is a schematic cross-sectional view that shows a multi-junction thin-film photoelectric conversion device in accordance with one embodiment of the invention.
FIG. 4 is a schematic cross-sectional view that shows a multi-junction thin-film photoelectric conversion device in accordance with one embodiment of the invention.

### DESCRIPTION OF EMBODIMENTS

Referring to the drawings, preferred embodiments of the present invention will be described below. In the drawings of this application, dimensional relationships, such as thickness and length, are properly altered as needed for clarity and simplicity of the drawings, and do not correspond to actual dimensions. In addition, in the respective drawings, the same reference characters represent the same members or the corresponding portions. In the present specification, the terms "crystalline" and "microcrystalline" are applied to a state in which an amorphous structure is partially included, as has been used in the relevant technical field.

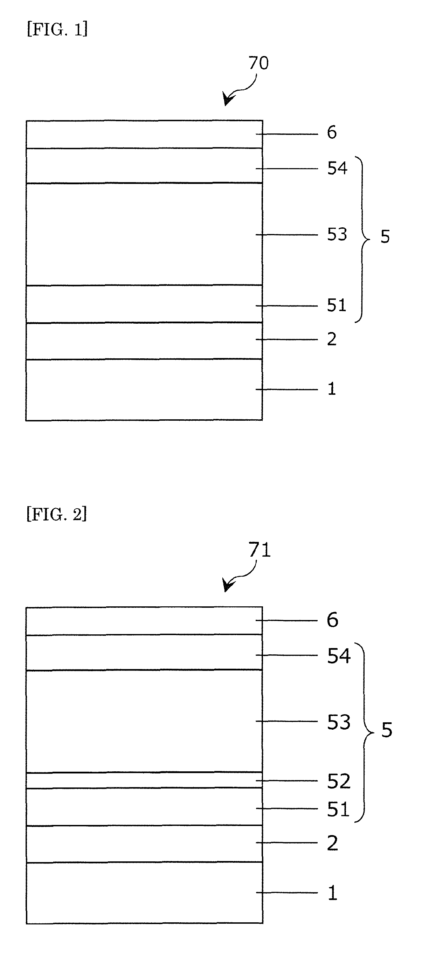

FIG. 1 is schematic sectional view of a thin-film photoelectric conversion device 70 according to one embodiment of the present invention. In the thin-film photoelectric conversion device, a transparent electrode layer 2, an amorphous germanium photoelectric conversion unit 5 and a back electrode layer 6 are arranged in this order on a transparent substrate 1. This thin-film photoelectric conversion device 70 has a structure in which light is made incident from the substrate 1 side. Generally in the thin-film photoelectric conversion device, an electrode layer and a photoelectric conversion unit are divided into a plurality of strip-shaped cells, and the plurality of cells are connected in series or in parallel to perform integration. When a method is used in which laser light is applied from the substrate side for integration, preferably the thin-film photoelectric conversion device has a structure in which light is made incident from the substrate 1 side as shown in FIG. 1 from the viewpoint of facility of performing integration.

The amorphous germanium photoelectric conversion unit 5 includes a substantially intrinsic amorphous germanium photoelectric conversion layer 53 between a p-type semiconductor layer and an n-type semiconductor layer. The mobility of hole is generally smaller than the mobility of electron, and therefore in the thin-film photoelectric conversion device, conversion efficiency becomes higher when the p-type layer is arranged on the light incident side. In summary, the amorphous germanium photoelectric conversion unit 5 is preferably one in which a p-type layer 51, an amorphous germanium photoelectric conversion layer 53 and an n-type layer 54 are stacked in this order from the substrate side (light incident side).

A plate-shaped member or a sheet-shaped member made of glass, a transparent resin or the like is used as the transparent substrate 1 in a photoelectric conversion device in which light is made incident from the substrate side. In particular, it is preferable to use a glass plate as the transparent substrate 1 for achieving high transmittance at low cost.

That is, since the transparent substrate 1 is arranged at the light incident side of the thin-film photoelectric conversion device, it is preferably made as transparent as possible so as to transmit as much sunlight as possible for absorption in the photoelectric conversion unit 5. For the same purpose, an anti-reflection coating is preferably formed on the light incident surface of the transparent substrate 1 so as to reduce light reflection loss on the incident surface of sunlight.

In a photoelectric conversion device in which light is incident from the substrate side, a transparent electrode layer as the first electrode layer 2 is formed on the substrate 1. The transparent electrode layer 2 is desirably as transparent as possible in order to allow sunlight to be transmitted for absorption into the photoelectric conversion unit, and is desirably electrically conductive so that holes generated in the photoelectric conversion unit are transported without loss.

Therefore, the transparent electrode layer 2 is preferably made from a conductive metal oxide such as tin oxide (SnO₂) or zinc oxide (ZnO), and preferably formed by using a method such as a chemical vapor deposition (CVD) method, a sputtering method or a vapor deposition method. The transparent electrode layer 2 is preferably provided with a fine irregular structure on its surface so as to increase scattering of the incident light.

The amorphous germanium photoelectric conversion unit 5 is formed, for example, by depositing a p-type semiconductor layer 51, an amorphous germanium photoelectric conversion layer 53 and an n-type semiconductor layer 54 in this order by a plasma enhanced CVD method.

The p-type semiconductor layer 51 may be made of one or more of crystalline silicon, amorphous silicon, crystalline silicon germanium, amorphous silicon germanium, crystalline germanium, and amorphous germanium, doped with a p-type impurity. The p-type semiconductor layer 51 can be formed by using the same deposition apparatus as that used in forming the amorphous germanium photoelectric conversion layer 53. In particular, as the p-type semiconductor layer 51, it is preferable to use microcrystalline silicon doped with 0.01 atom% or more of boron. When the p-type semiconductor layer 51 is made of microcrystalline silicon, movement of holes from the amorphous germanium photoelectric conversion layer 53 to the p-type semiconductor layer 51 will be smooth, so that it is more preferable.

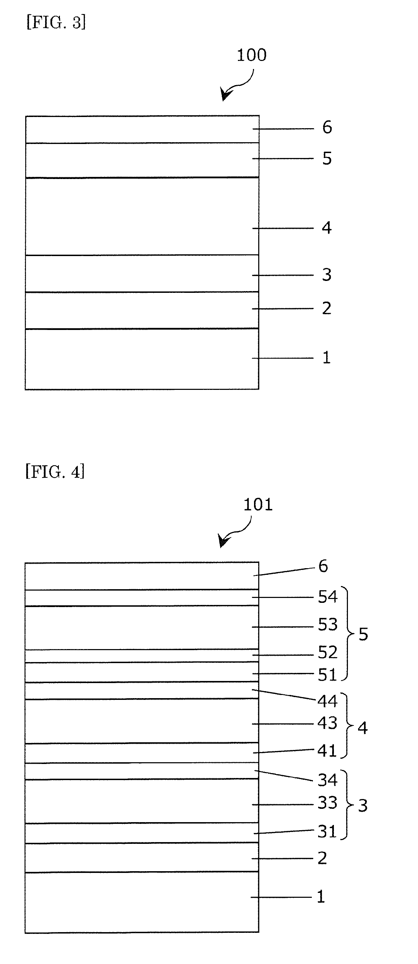

In the present invention, an interface layer 52 made of a substantially intrinsic amorphous silicon semiconductor may be arranged between the p-type semiconductor layer 51 and the amorphous germanium photoelectric conversion layer 53 as shown in FIG. 2. Plasma damage to photoelectric conversion units 3 and 4 during formation of the amorphous germanium photoelectric conversion layer 53 can be reduced by forming the amorphous silicon interface layer 52 on the p-type semiconductor layer 51, when other photoelectric conversion units 3 and 4 are formed on the substrate 1 side of the amorphous germanium photoelectric conversion unit 5 as shown in FIG. 3, for example. The amorphous silicon interface layer 52 can also contribute to reduction of a leak current in the multi-junction thin-film photoelectric conversion device. Preferably the amorphous silicon interface layer is formed so as to cover the entire surface of the p-type semiconductor layer 51.

The thickness of the amorphous silicon interface layer 52 is preferably 1 nm to 10 nm, more preferably 3 nm to 8 nm. When the thickness of the interface layer 52 is 1 nm or more, effects of reducing plasma damage and reducing a leak current are easily obtained, and the open circuit voltage and the fill factor of the stacked-type thin-film photoelectric conversion device are improved, so that conversion efficiency tends to be improved. When the amorphous silicon interface layer 52 is provided adjacently to the amorphous germanium photoelectric conversion layer 53, mismatching of band gaps occurs between both the layers, but when the thickness of the interface layer 52 is 10 nm or less, a carrier generated in the amorphous germanium photoelectric conversion layer 53 can pass through the interface layer 52 to arrive at the p-type layer 51 side owing to a tunnel effect. Thus, even when mismatching of band gaps occurs, a reduction in short circuit current is suppressed.

The amorphous germanium photoelectric conversion layer 53 is desired to be formed by a high frequency plasma-enhanced CVD method using GeH₄ and H₂ as a reaction gas. At this time, the H₂/GeH₄ flow ratio is preferably in a range of 1000 to 3000, more preferably in a range of 2000 to 2800. In the present invention, by diluting a germanium-containing gas such as germane (GeH₄) with an excessive hydrogen gas during formation of the amorphous germanium photoelectric conversion layer, defects in the amorphous germanium film are reduced and the band gap is narrowed, so that long-wavelength light can be efficiently absorbed. The reason why defects in the film are reduced by use of the condition of a high hydrogen dilution ratio is thought to be that a part having a weak germanium-germanium bond in the amorphous germanium film is selectively etched by hydrogen plasma to form a dense film. It is thought that since a film is formed at a high hydrogen dilution ratio, amorphous germanium is in a state immediately before crystallization, and due to a decrease in amount of hydrogen entrapped in the film, the hydrogen concentration of the film is lowered, so that the band gap is narrowed.

The germanium semiconductor layer tends to be easily crystallized when the hydrogen dilution ratio during deposition is high. When crystalline germanium is generated, the light absorption coefficient tends to decrease to deteriorate conversion efficiency of the photoelectric conversion device. Further, when crystalline germanium is generated, a leak current in the thin-film photoelectric conversion device may increase to deteriorate conversion efficiency. Thus, in the present invention, it is important to retain an amorphous state while forming a germanium semiconductor layer at a high hydrogen dilution ratio.

For retaining an amorphous state of the germanium semiconductor layer, the substrate temperature during deposition by plasma-enhanced CVD is preferably 250°C or lower, more preferably 230°C or lower, further preferably 200°C or lower, especially preferably 190°C or lower. When the substrate temperature during formation of the amorphous germanium photoelectric conversion layer is in the aforementioned range, diffusion of impurities from a conductivity-type layer (e.g. p-type layer 51) to the photoelectric conversion layer 53 is suppressed. In formation of the multi-junction thin-film photoelectric conversion device as shown in FIGs. 3 and 4, thermal damage to photoelectric conversion units 3 and 4 that are formed beforehand can be reduced.

The substrate temperature during formation of the amorphous germanium photoelectric conversion layer is preferably 120°C or higher, more preferably 140°C or higher, further preferably 150°C or higher. When the substrate temperature is in the aforementioned range, conversion efficiency tends to be improved because generation of particles during deposition is suppressed and a film having higher density is formed.

For forming the amorphous germanium photoelectric conversion layer 53 uniformly with a large area, it is desirable to form a film by a plasma-enhanced CVD method at a frequency of 10 to 100 MHz using a capacitive-coupling parallel plate electrode. Particularly, it is preferred to use a high-frequency power supply of 13.56 MHz, 27.12 Mz, 40 MHz or the like which is permitted for use industrially. For retaining an amorphous state, the high-frequency power density is preferably 1000 mW/cm² or less, more preferably 800 mW/cm² or less.

The thickness of the amorphous germanium photoelectric conversion layer 53 is preferably 20 nm to 300 nm, more preferably 100 nm to 250 nm. The thickness of the amorphous germanium photoelectric conversion layer 53 can be determined by observation of a cross section with a transmission electron microscope. The amorphous germanium photoelectric conversion layer 53 has an absorption coefficient larger than that of crystalline silicon and crystalline germanium. Therefore, long-wavelength light having a wavelength of 900 nm or more can be efficiently utilized for photoelectric conversion as long as the thickness of the amorphous germanium photoelectric conversion layer 53 is in the aforementioned range, irrespective of whether it is used for the single-junction thin-film photoelectric conversion device as shown in FIGs. 1 and 2 or for the multi-junction thin-film photoelectric conversion device as shown in FIGs. 3 and 4. When the thickness is 300 nm or less, there is an advantage that photodegradation is suppressed in addition to an advantage that the deposition time is reduced to improve productivity.

In the present invention, the amorphous germanium photoelectric conversion layer has an hydrogen content of preferably 5 atm% to 25 atm%, more preferably 10 atm% to 20 atm%. When the hydrogen content is 10 atm% or more, the dangling bond of germanium is terminated with hydrogen to reduce the defect density. When the hydrogen content is 30 atm% or less, the optical forbidden band width becomes smaller (band gap is narrowed), and therefore long-wavelength light having a wavelength of 900 nm or more can be efficiently absorbed to contribute to photoelectric conversion.

The n-type semiconductor layer 54 is preferably made of one or more of crystalline silicon, amorphous silicon, crystalline silicon germanium, amorphous silicon germanium, crystalline germanium and amorphous germanium, doped with an n-type impurity. By using any of these layers, a junction with the amorphous germanium photoelectric conversion layer 53 can be suitably formed. The n-type semiconductor layer 54 can be formed by using the same deposition apparatus as that used in forming the amorphous germanium photoelectric conversion layer 53.

For example, a silicon thin-film doped with phosphorus in an amount of 0.01 atom% or more can be used as the n-type semiconductor layer 54. As the n-type semiconductor layer, an amorphous silicon layer is more preferable than a crystalline silicon layer. This is considered to be because the amorphous silicon layer has an optical forbidden band width wider than that of the crystalline silicon layer, and therefore acts to suppress diffusion of holes from the amorphous germanium photoelectric conversion layer 53 to the n-type semiconductor layer 54, so that holes are prevented from recombining at the n-type semiconductor layer.

In a photoelectric conversion device having a configuration in which light is incident from the substrate side, a back electrode layer as a second electrode layer 6 is formed on the amorphous germanium photoelectric conversion unit 5. The back electrode layer 6 has a function of enhancing the efficiency of absorbing sunlight in the photoelectric conversion layer by reflecting the sunlight that has passed through the photoelectric conversion unit back to the photoelectric conversion unit side. For this reason, the back electrode layer 6 preferably has a high reflectivity to sunlight. Further, in order to transport the electrons generated in the photoelectric conversion unit without loss, the back electrode layer 6 is preferably electrically conductive. Therefore, the back electrode layer 6 is preferably formed from one or more metal layers made from at least one material selected from aluminum (Al), silver (Ag), gold (Au), cupper (Cu), platinum (Pt) and chromium (Cr), using a sputtering method or a vapor deposition method. In addition, a layer made from a conductive oxide such as ITO, SnO₂ or ZnO may be formed between the photoelectric conversion unit and the metal layer (not shown).

In the present invention, the amorphous germanium photoelectric conversion layer has less defects as described above, and therefore the fill factor and the open circuit voltage of the photoelectric conversion device are improved, so that conversion efficiency can be improved. As compared to photoelectric conversion layers made of silicon-based thin-films such as those of amorphous silicon, amorphous silicon carbide and crystalline silicon, the amorphous germanium photoelectric conversion layer can absorb light having a longer wavelength to contribute to photoelectric conversion. Therefore, the thin-film photoelectric conversion device of the present invention has high quantum efficiency for long-wavelength light. In examples of conventional techniques listed as prior art documents, the amorphous germanium photoelectric conversion device has a quantum efficiency of about 20% at a wavelength of 900 nm, whereas according to the present invention, the amorphous germanium photoelectric conversion unit (photoelectric conversion device) can have a quantum efficiency of 30% or more, particularly 40% or more at a wavelength of 900 nm.

The photoelectric conversion device may be in the form of single-junction of the amorphous germanium photoelectric conversion unit 5 as shown in FIGs. 1 and 2, but is preferably in the form of multi-junction with two or more photoelectric conversion units stacked as shown in FIG. 3. Particularly, in the case of a multi-junction thin-film photoelectric conversion device including other photoelectric conversion unit(s) on the light incident side of the amorphous germanium photoelectric conversion unit, even visible light and ultraviolet light having a wavelength shorter than 900 nm can be efficiently caused to contribute to photoelectric conversion, thereby improving conversion efficiency.

In the multi-junction thin-film photoelectric conversion device, the photoelectric conversion unit arranged on the light incident side of the amorphous germanium photoelectric conversion unit 5 is not particularly limited, but preferably the crystalline silicon photoelectric conversion unit 4 including a crystalline silicon photoelectric conversion layer is arranged. In the present invention, preferably the photoelectric conversion unit 3 including a photoelectric conversion layer having an optical forbidden band wider than that of crystalline silicon is arranged further on the light incident side of crystalline silicon photoelectric conversion unit 4. Examples of the above-mentioned photoelectric conversion unit include amorphous silicon-based photoelectric conversion units including amorphous silicon, amorphous silicon germanium or the like in a photoelectric conversion layer. Among them, an amorphous silicon photoelectric conversion unit including an amorphous silicon semiconductor layer as a photoelectric conversion layer is especially preferable.

Hereinafter, a triple-junction thin-film photoelectric conversion device including an amorphous silicon photoelectric conversion unit 3, a crystalline silicon photoelectric conversion unit 4 and an amorphous germanium photoelectric conversion unit 5 will be described as an example of the multi-junction thin-film photoelectric conversion device including an amorphous germanium photoelectric conversion unit.

FIG. 4 is a sectional view schematically showing a stacking structure of a triple-junction thin-film photoelectric conversion device in which light is made incident from the substrate 1 side and has an amorphous silicon photoelectric conversion unit as a top cell 3, a crystalline silicon photoelectric conversion unit as a middle cell 4 and an amorphous germanium photoelectric conversion unit as a bottom cell 5.

As a transparent substrate 1 and a first electrode layer (transparent electrode layer) 2, ones similar to those described above in connection with an example of the single-junction photoelectric conversion device are suitably used.

The amorphous silicon photoelectric conversion unit 3 includes a substantially intrinsic amorphous silicon photoelectric conversion layer 33 between a p-type layer 31 and an n-type layer 34. In the thin-film photoelectric conversion device in which light is made incident from the substrate 1 side, the amorphous silicon photoelectric conversion unit 3 preferably has the p-type layer 31, the photoelectric conversion layer 33 and the n-type layer 34 formed in this order by a plasma-enhanced CVD method. For example, a p-type amorphous silicon carbide layer 31 doped with boron in an amount of 0.01 atom% or more and having a thickness of 5 nm to 40 nm, a substantially i-type amorphous silicon photoelectric conversion layer 33 having a thickness of 50 nm to 400 nm and an n-type microcrystalline silicon layer 34 doped with phosphorus in an amount of 0.01 atom% or more and having a thickness of 5 nm to 40 nm are deposited in this order.

The crystalline silicon photoelectric conversion unit 4 includes a substantially intrinsic crystalline silicon photoelectric conversion layer 43 between a p-type layer 41 and an n-type layer 44. In the thin-film photoelectric conversion device in which light is made incident from the substrate 1 side, the crystalline silicon photoelectric conversion unit 4 preferably has the p-type layer 41, the photoelectric conversion layer 43 and the n-type layer 44 formed in this order by a plasma-enhanced CVD method. For example, the p-type microcrystalline silicon layer 41 doped with boron in an amount of 0.01 atom% or more and having a thickness of 5 to 40 nm, the substantially i-type crystalline silicon photoelectric conversion layer 42 having a thickness of 0.5 µm to 5 µm and the n-type microcrystalline silicon layer 44 doped with phosphorus in an amount of 0.01 atom% or more and having a thickness of 1 nm to 40 nm are deposited in this order.

As long as the amorphous silicon photoelectric conversion unit and the crystalline silicon photoelectric conversion unit have an amorphous silicon photoelectric conversion layer and a crystalline silicon photoelectric conversion layer, respectively, the stacking structure thereof is not limited to those described above. An intermediate reflection layer (not shown) etc. may be arranged between the photoelectric conversion units.

The amorphous germanium photoelectric conversion unit 5 is formed on a side opposite to the light incident side of the crystalline silicon photoelectric conversion unit 4. Details of the amorphous germanium photoelectric conversion unit 5 are similar to those described above in connection with an example of the single-junction photoelectric conversion device. As described above, in the thin-film photoelectric conversion device in which light is made incident from the substrate 1 side, it is preferable that an interface layer 52 including an amorphous silicon semiconductor is deposited on the p-type semiconductor layer 51 and the amorphous germanium photoelectric conversion layer 53 is deposited thereon as shown in FIG. 4.

On the amorphous germanium photoelectric conversion unit 5, a back electrode layer is formed as a second electrode layer 6 as in the case of an example of the single-junction photoelectric conversion device.

In the triple-junction thin-film photoelectric conversion device, the amorphous silicon photoelectric conversion unit 3 as a top cell absorbs principally light having a wavelength of 800 nm or less, and the crystalline silicon photoelectric conversion unit 4 and the amorphous germanium photoelectric conversion unit 5 absorb light having a longer wavelength, so that the light can be caused to contribute to photoelectric conversion. According to such a configuration, sunlight energy can be caused to contribute to photoelectric conversion over a wider wavelength range, and therefore a photoelectric conversion device excellent in conversion efficiency is obtained.

In the present invention, the crystalline silicon photoelectric conversion unit is arranged on the light incident side of the amorphous germanium photoelectric conversion unit 5, so that utilization efficiency of light having a wavelength longer than 900 nm is enhanced to improve conversion efficiency as shown later with comparison between Examples and Comparative Examples. This is because the amorphous germanium photoelectric conversion unit has a higher spectral sensitivity (quantum efficiency) to long-wavelength light having a wavelength of 900 nm or more, particularly 1000 nm or more as compared to the crystalline silicon photoelectric conversion unit.

As described above in connection with prior arts, since the optical forbidden band widths of amorphous germanium and crystalline silicon are almost comparable to each other, no attempt has been made heretofore to stack an amorphous germanium photoelectric conversion unit with a crystalline silicon photoelectric conversion unit in the same thin-film photoelectric conversion device to bring the units into multi-junction. On the other hand, in the present invention, film quality of amorphous germanium is improved to enhance the spectral sensitivity to long-wavelength light, and therefore long-wavelength light which has not been absorbed in the crystalline silicon photoelectric conversion layer is absorbed in the amorphous germanium photoelectric conversion layer positioned in the rear side thereof, so that conversion efficiency can be improved.

Further, since the amorphous germanium photoelectric conversion unit is arranged in the rear side of the crystalline silicon photoelectric conversion unit (on a side opposite to the light incident side), deterioration of photoelectric conversion characteristics associated with photodegradation of the amorphous germanium photoelectric conversion layer is suppressed. This is considered to be because since the crystalline silicon photoelectric conversion unit is arranged on the light incident side of the amorphous germanium photoelectric conversion layer, energy of light incident to the amorphous germanium photoelectric conversion layer is small, so that photodegradation of the amorphous germanium photoelectric conversion layer is suppressed.

Amorphous germanium is easily formed into a uniform film with a large area as compared to crystalline germanium. Further, since amorphous germanium has an absorption coefficient larger than that of crystalline germanium, the thickness of the photoelectric conversion layer can be decreased. Therefore, the multi-junction thin-film photoelectric conversion device including an amorphous germanium photoelectric conversion unit as a rear photoelectric conversion unit has the advantage that productivity can be enhanced as compared to the multi-junction thin-film photoelectric conversion device including a crystalline germanium photoelectric conversion unit.

A triple-junction photoelectric conversion device with an amorphous silicon photoelectric conversion unit, a crystalline silicon photoelectric conversion unit and an amorphous germanium photoelectric conversion unit stacked in this order has been described above as an example, but other stacking structures can be employed. For example, the photoelectric conversion device of the present invention may be a triple-junction photoelectric conversion device including an amorphous silicon germanium photoelectric conversion unit in place of an amorphous silicon photoelectric conversion unit, or a quadruple-junction photoelectric conversion device further including an amorphous silicon carbide photoelectric conversion unit between the amorphous silicon photoelectric conversion unit 3 and the crystalline silicon photoelectric conversion unit 4. The photoelectric conversion unit to be stacked with an amorphous germanium photoelectric conversion unit is not limited to a silicon-based thin-film photoelectric conversion unit, and may be one including a compound semiconductor layer such as that of CIS or CIGS as a photoelectric conversion layer.

Although FIGs. 1 to 4 shows a thin-film photoelectric conversion device in which light is made incident from the substrate side, it will be understood that the invention is effectively applied also to a thin-film photoelectric conversion device in which light is made incident from the side opposite to the substrate. In the case where light is made incident thereon from the side opposite to the substrate, for example, an arrangement may be made so that a substrate, a back electrode layer, an amorphous germanium photoelectric conversion unit and a transparent electrode layer are stacked in this order. In this case, the amorphous germanium photoelectric conversion unit is preferably formed by depositing an n-type semiconductor layer, an amorphous germanium photoelectric conversion layer and a p-type semiconductor layer in this order. The multi-junction photoelectric conversion device in which light is made incident from a side opposite to a substrate is formed by depositing, for example, a substrate, a back electrode layer, an amorphous germanium photoelectric conversion unit, a crystalline silicon photoelectric conversion unit, an amorphous photoelectric conversion unit and a transparent electrode layer in this order. In the thin-film photoelectric conversion device in which light is made incident from a side opposite to a substrate, the first electrode layer is a back electrode layer and the second electrode layer is a transparent electrode layer.

### EXAMPLES

Hereinafter, the present invention will be described in detail based on Examples according to the present invention, but the present invention is not limited to Examples below as long as the purpose thereof is maintained.

In Examples, Comparative Examples and a Reference Example described below, a glass substrate 1 with a thickness of 0.7 to 1.8 mm, on which a SnO₂ film having very small pyramid-shaped surface irregularities and having an average thickness of 700 nm was formed as a transparent electrode layer 2 by a thermal CVD method, was used. The transparent electrode layer 2 had a sheet resistance of 8 to 10 Ω/sq, a haze ratio of 10 to 25% as measured using a C light source in accordance with JIS K 7136, and an average elevation difference of surface irregularities of about 100 nm.

### <Preparation and Evaluation of Single-Junction Thin-film Photoelectric Conversion Device>

### (Example 1)

As Example 1, a single-junction amorphous germanium thin-film photoelectric conversion device shown in FIG. 2 was prepared.

An amorphous germanium photoelectric conversion unit 5 was formed on the transparent electrode layer 2 using a capacitive-coupling high-frequency plasma-enhanced CVD device including a parallel plate electrode with a frequency of 13.56 MHz.

First, SiH₄, H₂ and B₂H₆ were introduced as reaction gases to form a p-type microcrystalline silicon layer 51 with a thickness of 10 nm. Thereafter, SiH₄ and H₂ were introduced as reaction gases to form a substantially intrinsic amorphous silicon layer 52 with a thickness of 5 nm.

Thereafter, GeH₄ and H₂ were introduced to form an amorphous germanium photoelectric conversion layer 53 with a thickness of 200 nm. Deposition conditions included a H₂/GeH₄ flow ratio of 2600, a substrate temperature of 180°C, a pressure of 930 Pa and a high-frequency power density of 650 mW/cm².

Subsequently, SiH₄, H₂ and PH₃ were introduced as reaction gases to form an n-type amorphous silicon layer 54 with a thickness of 20 nm. On the photoelectric conversion unit 5, an Al-doped ZnO film having a thickness of 90 nm and an Ag film having a thickness of 300 nm were sequentially formed as a back electrode layer 6 using a sputtering method.

After formation of the back electrode layer 6, the film formed on the glass substrate 1 was partially removed by a laser scribing method to be divided into a size of 1 cm², thereby obtaining a single-junction thin-film photoelectric conversion device (light reception area: 1 cm²).

### (Comparative Example 1)

In Comparative Example 1, an amorphous silicon photoelectric conversion unit including an amorphous silicon semiconductor layer as a photoelectric conversion layer was formed on a transparent electrode layer 2 using a capacitive-coupfing high-frequency plasma-enhanced CVD device including a parallel plate electrode with a frequency of 13.56 MHz.

SiH₄, H₂, CH₄ and B₂H₆ were introduced as reaction gases to form a p-type amorphous silicon carbide layer with a thickness of 15 nm, and SiH₄ was then introduced as a reaction gas to form a substantially intrinsic amorphous silicon photoelectric conversion layer with a thickness of 300 nm. Thereafter, SiH₄, H₂ and PH₃ were introduced as reaction gases to form an n-type microcrystalline silicon layer with a thickness of 10 nm.

A back electrode layer was formed on the amorphous silicon photoelectric conversion unit in the same manner as in Example 1, and then divided into a size of 1 cm² to obtain a single-junction thin-film photoelectric conversion device.

### (Comparative Example 2)

In Comparative Example 2, a crystalline silicon photoelectric conversion unit including a crystalline silicon semiconductor layer as a photoelectric conversion layer was formed on a transparent electrode layer 2 using a capacitive-coupling high-frequency plasma-enhanced CVD device including a parallel plate electrode with a frequency of 13.56 MHz.

SiH₄, H₂ and B₂H₆ were introduced as reaction gases to form a p-type microcrystalline silicon layer with a thickness of 20 nm, and SiH₄ and H₂ were then introduced as reaction gases to form a substantially intrinsic crystalline silicon photoelectric conversion layer with a thickness of 2.3 µm. Thereafter, SiH₄, H₂ and PH₃ were introduced as reaction gases to form an n-type microcrystalline silicon layer with a thickness of 30 nm.

A back electrode layer was formed on the crystalline silicon photoelectric conversion unit in the same manner as in Example 1, and then divided into a size of 1 cm² to obtain a single-junction thin-film photoelectric conversion device.

### (Comparative Example 3)

As Comparative Example 3, the configuration of an amorphous germanium thin-film photoelectric conversion device described in the aforementioned Non-Patent Document 1 (J. Zhu et al., Journal of Non-Crystalline Solids, 338-340 (2004), pages 651 to 654) is shown. The thin-film photoelectric conversion device includes, from the substrate side, an n-type amorphous silicon layer doped with phosphorus, a band gap adjustment layer having a thickness of about 20 nm, an amorphous germanium photoelectric conversion layer having a thickness of 150 to 200 nm, a buffer layer, an amorphous silicon carbide layer doped with boron and an ITO transparent electrode layer. The amorphous germanium photoelectric conversion layer was formed under conditions of a H₂/GeH₄ flow ratio of 50 or more and a substrate temperature of 250 to 275°C using a remote ECR plasma method.

### (Evaluation of Example 1 and Comparative Examples 1 and 2)

Each of the single-junction thin-film photoelectric conversion devices obtained in Examples 1 and Comparative Examples 1 and 2 was irradiated with light of AM 1.5 in a light amount of 100 mW/cm² and output characteristics were measured. Further, the spectral sensitivity of each photoelectric conversion device was measured. Output characteristics and quantum efficiency η at a wavelength of 900 nm for the photoelectric conversion devices are shown in Table 1. Table 1 also shows characteristics of the amorphous germanium thin-film photoelectric conversion device of Comparative Example 3 described in Non-Patent Document 1.

**[Table 1]**

| | cell stacking configuration | Jsc (mA/cm²) | Voc (V) | FF | Eff (%) | η @900 nm (%) |
|---|---|---|---|---|---|---|
| Example 1 | a-Ge; single-junction | 28.7 | 0.32 | 0.68 | 6.24 | 53 |
| Comparative Example 1 | µc-Si; single-junction | 23.5 | 0.48 | 0.70 | 7.90 | 21 |
| Comparative Example 2 | a-Si; single-junction | 15.3 | 0.89 | 0.74 | 10.08 | 0 |
| Comparative Example 3 | a-Ge; single-junction (prior art) | 14.0 | 0.40 | 0.59 | 3.30 | 17 |

Quantum efficiency at a wavelength of 900 nm for the amorphous germanium thin-film photoelectric conversion device of Example 1 is about 2.5 times as high as that of the crystalline silicon thin-film photoelectric conversion device of Comparative Example 2. It is apparent that the amorphous germanium photoelectric conversion device according to the present invention can utilize light having a longer wavelength for photoelectric conversion more effectively, as compared to the crystalline silicon photoelectric conversion device. The amorphous silicon thin-film photoelectric conversion device of Comparative Example 1 could not utilize light having a wavelength of 900 nm for photoelectric conversion.

The short circuit current density Jsc of the amorphous germanium thin-film photoelectric conversion device of Example 1 was about 1.2 times as high as that of the crystalline silicon thin-film photoelectric conversion device of Comparative Example 2, and about 1.9 times as high as that of the amorphous silicon photoelectric conversion device of Comparative Example 1.

As a result of closely examining spectral sensitivity characteristics in a long wavelength region for thin-film photoelectric conversion devices of Example 1 and Comparative Example 2, the amorphous germanium thin-film photoelectric conversion device of Example 1 showed a wavelength in which a quantum efficiency decreases to 10% that is shifted to the longer wavelength side by 100 nm or more, as compared to the crystalline silicon thin-film photoelectric conversion device of Comparative Example 2. On the other hand, the crystalline silicon thin-film photoelectric conversion device had higher quantum efficiency in a wavelength region of shorter than 500 nm.

In the amorphous germanium thin-film photoelectric conversion device of Example 1, the short circuit current density was higher by a factor of about 2, quantum efficiency for light having a wavelength of 900 nm was higher by a factor of about 3, and the fill factor FF was improved as compared to the amorphous germanium photoelectric conversion device of Comparative Example 3. On the other hand, it is apparent that the amorphous germanium thin-film photoelectric conversion device of Example 1 has a decreased open circuit voltage Voc and a small band gap as compared to Comparative Example 3. From these results, it can be understood that the amorphous germanium thin-film photoelectric conversion device according to the present invention has a reduced number of defects and a narrowed band gap and is thus excellent in utilization of long-wavelength light as compared to amorphous germanium thin-film photoelectric conversion devices of conventional techniques.

From the results described above, it is apparent that according to the present invention, an amorphous germanium photoelectric conversion device or amorphous germanium photoelectric conversion unit excellent in utilization of long-wavelength light is obtained. A thin-film photoelectric conversion device including the amorphous germanium photoelectric conversion unit has a smaller optical forbidden band width of a photoelectric conversion layer and is thus excellent in photoelectric conversion characteristics in a long wavelength region as compared to a thin-film photoelectric conversion device using a crystalline silicon photoelectric conversion unit. Therefore, it is suggested that when an amorphous germanium photoelectric conversion unit is arranged in the rear side of a crystalline silicon photoelectric conversion unit to form a stacked-type thin-film photoelectric conversion device, light in a wider wavelength region can be caused to contribute to photoelectric conversion, so that conversion efficiency can be improved.

Hitherto, amorphous germanium has been reported to have a band gap of about 1.1 eV, which is substantially equal to that of crystalline silicon. Since amorphous germanium does not have sufficient photoelectric conversion characteristics in a long wavelength region due to difficulty to improve film quality so that photodegradation easily occurs, no attempt has been made to prepare a multi-junction thin-film photoelectric conversion device by combining an amorphous germanium photoelectric conversion unit and a crystalline silicon photoelectric conversion unit.

On the other hand, according to the present invention, long-wavelength light can be more effectively utilized by an amorphous germanium photoelectric conversion unit than a crystalline silicon photoelectric conversion unit. Therefore, it is suggested that when an amorphous germanium photoelectric conversion unit is further stacked as a bottom cell on a multi-junction thin-film photoelectric conversion device used practically heretofore, in which an amorphous silicon-based photoelectric conversion unit and a crystalline silicon photoelectric conversion unit are stacked, efficiency of the multi-junction thin-film photoelectric conversion device can be further enhanced.

### <Preparation and Evaluation of Single-Junction Thin-film Photoelectric Conversion Device>

Hereinafter, based on the findings obtained through evaluation of the above-described single-junction thin-film photoelectric conversion device, a multi-junction thin-film photoelectric conversion device was prepared and studies for improving efficiency was conducted.

### (Example 2)

As Example 2, a triple-junction thin-film photoelectric conversion device having a structure shown in FIG. 4 was prepared.

First, an amorphous silicon photoelectric conversion unit 3 was formed on a transparent electrode layer 2 using a capacitive-coupling high-frequency plasma-enhanced CVD device including a parallel plate electrode with a frequency of 13.56 MHz. SiH₄, H₂, CH₄ and B₂H₆ were introduced as reaction gases to form a p-type amorphous silicon carbide layer 31 with a thickness of 15 nm, and SiH₄ was then introduced as a reaction gas to form a substantially intrinsic amorphous silicon photoelectric conversion layer 32 with a thickness of 200 nm. Thereafter, SiH₄, H₂ and PH₃ were introduced as reaction gases to form an n-type amorphous silicon layer 33 with a thickness of 10 nm.

After formation of the amorphous silicon photoelectric conversion unit 3, SiH₄, H₂ and B₂H₆ were introduced as reaction gases to form a p-type microcrystalline silicon layer 41 with a thickness of 10 nm. Thereafter, SiH₄ and H₂ were introduced as reaction gases to form a substantially intrinsic crystalline silicon photoelectric conversion layer 42 with a thickness of 1.8 µm. Thereafter, SiH₄, H₂ and PH₃ were introduced as reaction gases to form an n-type microcrystalline silicon layer 43 with a thickness of 15 nm, so that a crystalline silicon photoelectric conversion unit 4 was formed.

After formation of the crystalline silicon photoelectric conversion unit 4, SiH₄, H₂ and B₂H₆ were introduced as reaction gases to form a p-type microcrystalline silicon layer 51 with a thickness of 10 nm. Thereafter, SiH₄ and H₂ were introduced as reaction gases to form a substantially intrinsic amorphous silicon layer 52 with a thickness of 5 nm. Thereafter, GeH₄ and H₂ were introduced to form an amorphous germanium photoelectric conversion layer 53 with a thickness of 200 nm. Deposition conditions included a H₂/GeH₄ flow ratio of 2600, a substrate temperature of 180°C, a pressure of 930 Pa and a high-frequency power density of 650 mW/cm².

Thereafter, SiH₄, H₂ and PH₃ were introduced as reaction gases to form an n-type amorphous silicon layer 54 with a thickness of 20 nm, so that an amorphous germanium photoelectric conversion unit 5 was formed.

On the amorphous germanium photoelectric conversion unit, a B-doped ZnO film having a thickness of 70 nm, an Al-doped ZnO film having a thickness of 30 nm and an Ag film having a thickness of 300 nm were sequentially stacked by a sputtering method to form a back electrode layer 6. Thereafter, in the same manner as in Example 1, the layers were divided into a size of 1 cm² by laser scribing to obtain a triple-junction thin-film photoelectric conversion device.

### (Example 3)

In Example 3, a triple-junction thin-film photoelectric conversion device was obtained in the same manner as in Example 2 except that the thickness of the substantially intrinsic amorphous silicon layer 52 in the amorphous germanium photoelectric conversion unit 5 was changed to 10 nm.

### (Example 4)

In Example 4, a triple-junction thin-film photoelectric conversion device was obtained in the same manner as in Example 2 except that in formation of the amorphous germanium photoelectric conversion unit 5, the substantially intrinsic amorphous silicon layer 52 was not formed, but the amorphous germanium photoelectric conversion layer 53 was formed directly on the p-type microcrystalline silicon layer 51.

### (Example 5)

In Example 5, a triple-junction thin-film photoelectric conversion device was obtained in the same manner as in Example 2 except that the thickness of the substantially intrinsic amorphous silicon layer 52 in the amorphous germanium photoelectric conversion unit 5 was changed to 20 nm.

### (Comparative Example 4)

As Comparable Example 4, a double-junction thin-film photoelectric conversion device, in which an amorphous silicon photoelectric conversion unit and a crystalline silicon photoelectric conversion unit were stacked, was prepared.

An amorphous silicon photoelectric conversion unit and a crystalline photoelectric conversion unit were formed on a transparent electrode layer 2 in the same manner as in Example 2. Deposition conditions and the thickness etc. for these photoelectric conversion units were the same as those in Example 2 except that the thickness of the amorphous silicon photoelectric conversion layer was changed to 260 nm and the thickness of the crystalline silicon photoelectric conversion layer was changed to 2.5 µm.

Thereafter, an amorphous germanium photoelectric conversion unit was not formed, but a back electrode layer was formed on the crystalline silicon photoelectric conversion unit in the same manner as in Example 2, and then divided into a size of 1 cm² to obtain a double-junction thin-film photoelectric conversion device.

### (Reference Example 1)

As Reference Example 1, a triple-junction thin-film photoelectric conversion device, in which an amorphous silicon photoelectric conversion unit, an amorphous germanium photoelectric conversion layer and a crystalline silicon photoelectric conversion unit were stacked in this order, was prepared.

In Reference Example 1, photoelectric conversion units were formed in the same deposition conditions and thickness as those in Example 2 except that the stacking order of the photoelectric conversion units was changed to the order of amorphous silicon photoelectric conversion unit / amorphous germanium photoelectric conversion unit/crystalline silicon photoelectric conversion unit. Thereafter, a back electrode layer was formed on the crystalline silicon photoelectric conversion unit in the same manner as in Example 2, and then divided into a size of 1 cm² to obtain a triple-junction thin-film photoelectric conversion device.

### (Comparative Example 5)

As Comparative Example 5, the configuration of a multi-junction thin-film photoelectric conversion device described in the foregoing Patent Document 2 (Japanese Patent Laid-open Publication No. 1-246362) is shown. The multi-junction thin-film photoelectric conversion device is a quadruple-junction thin-film photoelectric conversion device in which an amorphous silicon photoelectric conversion unit, an amorphous silicon photoelectric conversion unit, an amorphous silicon germanium photoelectric conversion unit and an amorphous germanium photoelectric conversion unit are sequentially stacked on a transparent electrode layer. The amorphous germanium photoelectric conversion layer was formed under conditions of a H₂/GeH₄ flow ratio of 5 to 100 and a substrate temperature of 150 to 350°C using a plasma-enhanced CVD method.

Each of the multi-junction thin-film photoelectric conversion devices of Examples 2 to 5, Comparative Example 4 and Reference Example 1 was irradiated with light of AM 1.5 in a light amount of 100 m W/cm² and output characteristics were measured. The results are shown in Table 2. Table 2 also shows characteristics of the multi-junction thin-film photoelectric conversion device of Comparative Example 5 described in Patent Document 2. The "overall current" in Table 2, which is known to serve as an indication for determining how much of sunlight is effectively utilized by the stacked-type photoelectric converter, is a product of a short circuit current density and photoelectric conversion units.

**[Table 2]**

| | cell stacking configuration | interface layer thickness (nm) | Jsc (mA/cm²) | Voc (V) | FF | Eff (%) | Eff' (%) | decreasing rate (%) | η@900nm (%) | overall current (mA/cm²) |
|---|---|---|---|---|---|---|---|---|---|---|
| Example 2 | a-Si/µc-Si/a-Ge: triple-junction | 5 | 10.01 | 1.64 | 0.72 | 11.89 | 11.30 | 5 | 51 | 30.0 |
| Example 3 | a-Si/pe-Si/a-Ge; triple-junction | 10 | 9.23 | 1.59 | 0.75 | 11.07 | 10.51 | 5 | 43 | 27.7 |
| Example 4 | a-Si/pe-Si/a-Ge; triple-junction | | 9.54 | 1.55 | 0.74 | 11.02 | 10.46 | 5 | 47 | 28.6 |
| Example 5 | a-Si/µc-Si/a-Ge; triple-junction | 20 | 8.43 | 1.71 | 0.76 | 10.97 | 10.42 | 5 | 32 | 25.3 |
| Comparative Example 4 | a-Si/µc-Si; double-junction | - | 11.50 | 1.37 | 0.73 | 11.50 | 10.35 | 10 | 23 | 23.0 |
| Reference Example 1 | a-Si/a-Ge/µc-Si; triple-junction | 5 | 8.30 | 1.63 | 0.73 | 9.88 | 8.39 | 15 | - | 24.9 |
| Comparative Example 5 | a-Si/a-Si/µc-Si/a-Ge; quadruple-junction | - | 5.60 | 2.55 | 0.64 | 9.14 | NA | | NA | 22.4 |

The thin-film photoelectric conversion device of Example 2 has a short circuit current density higher by about 20% and conversion efficiency higher by about 20% as compared to the thin-film photoelectric conversion device of Reference Example 1. The triple-junction thin-film photoelectric conversion device of Example 2 shows higher values for both the short circuit current density and overall current, and has conversion efficiency higher by about 30% as compared to the quadruple-junction thin-film photoelectric conversion device of Comparative Example 5.

The triple-junction thin-film photoelectric conversion device of Example 2 has an open circuit voltage higher by about 20% as compared to the double-junction thin-film photoelectric conversion device of Comparative Example 4. In Example 2, the short circuit current density is lower by about 10% than that in Comparative Example 4, but there is an increase of about 30% in terms of an overall current, and therefore it is apparent that sunlight can be more effectively utilized.

### [Evaluation of Photodegradation Characteristics]

The multi-junction thin-film photoelectric conversion devices of Example 2, Reference Example 1 and Comparative Example 4 were each adjusted to have a temperature of 50°C, and continuously irradiated with 5 SUN-equivalent light for 20 hours to evaluate photodegradation characteristics. The results are shown in Table 2.

For the triple-junction thin-film photoelectric conversion device of Example 2, the decreasing rate of conversion efficiency Eff' after photodegradation was 5% with respect to initial conversion efficiency Eff, whereas the decreasing rate for the double-junction thin-film photoelectric conversion device of Comparative Example 4 was 10% and the decreasing rate for the triple-junction thin-film photoelectric conversion device of Reference Example 1 was 15%.

From these results, it is apparent that the triple-junction thin-film photoelectric conversion device of Example 2 has reduced photodegradation although using a plurality of amorphous photoelectric conversion units like Reference Example 1. This is considered to be because in Example 2, the amorphous germanium photoelectric conversion layer is arranged on the rear side of the crystalline silicon photoelectric conversion unit, and therefore energy of light incident to the amorphous germanium photoelectric conversion layer is small, so that photodegradation of the amorphous germanium photoelectric conversion layer hardly occurs.

It is apparent that although using a plurality of amorphous photoelectric conversion units, the triple-junction thin-film photoelectric conversion device of Example 2 has reduced photodegradation and high post-light stabilization characteristics as compared to the double-junction thin-film photoelectric conversion device of Comparative Example 4 which includes one amorphous photoelectric conversion unit. This is considered to be because in the triple-junction thin-film photoelectric conversion device of Example 2, the thickness of the amorphous silicon photoelectric conversion layer in the top cell can be reduced as compared to a case of double-junction, and therefore photodegradation of amorphous silicon is small and also energy of light incident to the amorphous germanium photoelectric conversion layer in the bottom cell is low, so that photodegradation hardly occurs.

From the results described above, it is apparent that when an amorphous germanium photoelectric conversion layer is added between a crystalline photoelectric conversion unit and a back electrode, long-wavelength light can be more effectively utilized, leading to improvement of conversion efficiency. Particularly, it is apparent that when an amorphous germanium photoelectric conversion unit as a bottom cell is added to a double-junction thin-film solar cell with an amorphous silicon-based photoelectric conversion unit/crystalline silicon photoelectric conversion unit, which has been practically used heretofore, thereby forming a triple-junction structure, a stacked-type thin-film photoelectric conversion device having initial conversion efficiency improved, photodegradation suppressed, and excellent conversion efficiency after photodegradation (post-stabilization conversion efficiency) is obtained.

### [Effect of Amorphous Silicon Interface Layer]

The thin-film photoelectric conversion device of Example 2, in which on a p-type semiconductor layer, an amorphous silicon interface layer having a thickness of 5 nm is formed, and an amorphous germanium photoelectric conversion layer is formed thereon in an amorphous germanium photoelectric conversion unit, has conversion efficiency higher by about 7% as a result of improvement of the open circuit voltage and the short circuit current density as compared to the thin-film photoelectric conversion device of Example 4 which does not have an amorphous silicon interface layer. Further, in Example 3 and Example 5 where the thickness of the amorphous silicon interface layer is 10 nm and 20 nm, respectively, the open circuit voltage is improved as compared to Example 4. On the other hand, in Example 3 and Example 5, the short circuit current density tended to decrease as the thickness of the amorphous silicon interface layer increased.

From the results described above, it is apparent that when an amorphous silicon interface layer is formed before formation of an amorphous germanium photoelectric conversion layer, principally the open circuit voltage is improved, leading to improvement of conversion efficiency. On the other hand, it is apparent that when the thickness of the amorphous silicon interface layer is excessively large, the short circuit current density tends to decrease, and therefore the thickness of the amorphous silicon interface layer is particularly preferably in a range of about 1 nm to 10 nm.

The triple-junction thin-film photoelectric conversion devices of Examples 3 to 5 have initial conversion efficiency equal to or lower than that of the double-junction thin-film photoelectric conversion device of Comparative Example 4, but show a higher value in terms of post-stabilization conversion efficiency Eff as compared to Comparative Example 4 because photodegradation is suppressed. In the thin-film solar cell, post-stabilization conversion efficiency after photodegradation is an indication which more directly indicates performance of the solar cell in practical use, and thus the thin-film photoelectric conversion devices of Examples 3 to 5 may have improved characteristics as compared to the double-junction thin-film photoelectric conversion device of Comparative Example 4.

### DESCRIPTION OF REFERENCE CHARACTERS

- 1.: Transparent substrate
- 2.: Transparent electrode layer
- 3.: Amorphous silicon photoelectric conversion unit
- 4.: Crystalline silicon photoelectric conversion unit
- 5.: Amorphous germanium photoelectric conversion unit
- 51.: p-type semiconductor layer
- 52.: Amorphous silicon layer
- 53.: Amorphous germanium photoelectric conversion layer
- 54.: n-type semiconductor layer
- 6.: Back electrode layer

## Claims

1. A multi-junction thin-film photoelectric conversion device comprising: a first electrode layer; two or more of photoelectric conversion units; and a second electrode layer, arranged in this order on a substrate,
wherein each of the photoelectric conversion unit comprises a substantially intrinsic photoelectric conversion layer between a p-type semiconductor layer and an n-type semiconductor layer,
one of the two or more photoelectric conversion units is an amorphous germanium photoelectric conversion unit comprising an amorphous germanium photoelectric conversion layer essentially free of silicon atom, and
a crystalline silicon photoelectric conversion unit comprising a crystalline silicon photoelectric conversion layer is arranged on the light incident side of the amorphous germanium photoelectric conversion unit.

2. The thin-film photoelectric conversion device according to claim 1, wherein the amorphous germanium photoelectric conversion unit has a quantum efficiency of 30% or more at a wavelength of 900 nm.

3. The thin-film photoelectric conversion device according to claim 1 or 2, wherein an amorphous silicon-based photoelectric conversion unit comprising an amorphous silicon-based photoelectric conversion layer is arranged on the light incident side of the crystalline silicon photoelectric conversion unit.

4. The thin-film photoelectric conversion device according to any one of claims 1 to 3, wherein in the amorphous germanium photoelectric conversion unit, an interface layer made of a substantially intrinsic amorphous silicon semiconductor is provided between the p-type semiconductor layer and the amorphous germanium photoelectric conversion layer.

5. The thin-film photoelectric conversion device according to claim 4, wherein the thickness of the interface layer is 1 nm to 10 nm.

6. A thin-film photoelectric conversion device comprising: a first electrode layer; an amorphous germanium photoelectric conversion unit; and a second electrode layer, arranged in this order on a substrate,
wherein the amorphous germanium photoelectric conversion unit comprises an amorphous germanium photoelectric conversion layer, which is substantially intrinsic and is essentially free of silicon atom, between a p-type semiconductor layer and an n-type semiconductor layer, and
the amorphous germanium photoelectric conversion unit has a quantum efficiency of 30% or more at a wavelength of 900 nm.

7. A method for manufacturing the thin-film photoelectric conversion device according to any one of claims 1 to 6,
wherein the amorphous germanium photoelectric conversion layer is formed by a plasma-enhanced CVD method, and
in the plasma-enhanced CVD. a hydrogen gas in an amount which is 1000 to 3000 times the amount of a germanium containing gas is introduced into a deposition chamber.
